# EUROPÄISCHE PATENTSCHRIFT

(11) **EP 1 745 518 B1**
(45) Veröffentlichungstag und Bekanntmachung des Hinweises auf die Patenterteilung: **09.07.2008**
(21) Anmeldenummer: 05739511.3
(22) Anmeldetag: 10.05.2005
(51) Int. Cl.: H01L 31/0304, H01L 31/05, H01L 31/068, H01L 27/142

(54) **SOLARZELLE MIT INTEGRIERTER SCHUTZDIODE**
SOLAR CELL WITH INTEGRATED PROTECTIVE DIODE
CELLULE SOLAIRE A DIODE DE PROTECTION INTEGREE

(30) Priorität: 12.05.2004 DE 102004023856
(43) Veröffentlichungstag der Anmeldung: 24.01.2007
(73) Patentinhaber: AZUR SPACE Solar Power GmbH, 74072 Heilbronn (DE)
(72) Erfinder: STROBL, Gerhard, 70439 Stuttgart (DE)
(74) Vertreter: Stoffregen, Hans-Herbert
(86) Internationale Anmeldenummer: PCT/EP2005/005013
(87) Internationale Veröffentlichungsnummer: WO 2005/112131

(56) Entgegenhaltungen:
- US-A1- 2002 117 675
- US-A1- 2002 144 724
- US-B1- 6 316 716
- US-B1- 6 635 507
- STAN M.A. ET AL.: "The development of >28% efficient triple-junction space solar cells at Emcore Photovoltaics" PROC. OF 3RD WORLD CONF. ON PHOTOVOLTAIC ENERGY CONVERSION, Bd. 1, 11. Mai 2003 (2003-05-11), - 18. Mai 2003 (2003-05-18) Seiten 662-665, XP008053707 Arisumi Printing Inc Japan

## Beschreibung

Die Erfindung bezieht sich auf eine Solarzelle mit zwischen Front- und Rückkontakt verlaufenden photoaktiven Halbleiterschichten mit integraler mit dem Frontkontakt verbindbarer Schutzdiode (Bypass-Diode) mit einer der Solarzelle entgegen gerichteten Polarität und frontseitig verlaufender p-leitender Halbleiterschicht, auf der eine Tunneldiode verläuft.

In großflächigen Dioden von mehreren Quadratzentimeterflächen, wie diese Solarzellen aus Halbleitermaterial mit wenigstens einem p/n-Übergang bilden, sind Mikrokurzschlüsse, d. h. lokale, kleindimensionierte elektrische (ohmsche) Verbindungen über den p/n-Übergang des Halbleitermaterials oft unvermeidbar. Diese entstehen zum Beispiel durch Oberflächenverletzungen während der Substratherstellung, im Kristall oder durch Dotierstoffanhäufungen zum Beispiel an Kristallstörungen wie Versetzungen, insbesondere bei der Ausbildung von epitaxierten p/n-Übergängen bei zum Beispiel Solarzellen Elemente der Gruppe III - IV des Periodensystems.

Normalerweise stören die so entstehenden Mikrokurzschlüsse die Funktion der Diode als Solarzelle in Flussrichtung kaum oder nur in geringem Umfang. Die Fehlstellungen können jedoch bei Betrieb der Zelle in Sperrrichtung zu einer Zerstörung der Zelle führen. Sind zum. Beispiel mehrere Solarzellen oder -generatoren seriell in einem so genannten String auf einem Solararray miteinander verbunden, so wird bei sperrendem p/n-Übergang eines Generators - dies kann z. B. durch Abschattung oder Bruch der Solarzelle bewirkt werden - der Solarstrom von der hohen String-Spannung der restlichen beleuchteten Solarzellen oder -generatoren durch die ohmschen MikroKurzschlüsse gepresst. Dies kann zu einer starken lokalen Erhitzung, Umdotierung zur Niederohmigkeit, d. h. lokaler starker Entartung des Halbleiters und letztendlich zur Zerstörung der Zelle selbst führen.

Zur Vermeidung entsprechender lokaler starker Erhitzungen, so genannten Hot-Spots, ist es bei seriell geschalteten Solarzellen bekannt, parallel zu den Solarzellen liegende Schutzdioden anzuordnen, deren Flussrichtung entgegen der Solarzellen verlaufen.

Eine Kaskaden- oder Multijunction-Solarzelle mit integrierter Schutzdiode der eingangs genannten Art ist der WO-A-00/44052 zu entnehmen.

Aus der EP-A-1 056 137 ist eine Solarzelle bekannt, bei der die Schutzdiodenhalbleiterschicht bereichsweise von einer Schicht der Solarzelle selbst ausgebildet wird, wobei die photoaktiven Schichten beabstandet zu dem Bereich der Solarzelle verlaufen, der die Schutzdiodenhalbleiterschicht bildet. Die Schutzdiode kann als eine Schottky-Diode, eine MIS-Kontakt-Diode, eine Diode mit p/n-Übergang oder als metalllegierte Diode ausgebildet sein.

Weitere Solarzellen mit integrierter Schutzdiode sind der US-A-2002/0179141, der US-B-6 600 100 oder der US-B-6 359 210 zu entnehmen. Bei den entsprechenden Solarzellen handelt es sich um so genannte Kaskadensolarzellen, bei denen mehrere Solarzellen übereinander angeordnet und über Tunneldioden voneinander getrennt sind. Die Solarzelle ist vom n/p-Typ. Infolgedessen ist die Schutzdiode vom p/n-Typ. Somit ist die frontkontaktseitige Halbleiterschicht ein Löcherleiter mit der Folge, dass eine Migration der Metallatome des Frontkontaktes erfolgt, wodurch die Diode instabil wird. Eine erhöhte Migration tritt insbesondere dann auf, wenn der Frontkontakt Silber enthält.

Der vorliegenden Erfindung liegt das Problem zu Grunde, eine Solarzelle der eingangs genannten Art so weiterzubilden, dass eine hohe Stabilität der Schutzdiode gewährleistet ist, also insbesondere eine Migration von Metallatomen unterbunden bzw. weitgehend unterbunden wird.

Erfindungsgemäß wird das Problem im Wesentlichen dadurch gelöst, dass auf der Tunneldiode eine n⁺-leitende Schicht verläuft, über die die Schutzdiode mit dem Frontkontakt verbunden oder verbindbar ist.

Erfindungsgemäß wird die Schutzdiode derart weitergebildet, dass unterhalb des Kontaktbereichs (Metallisierung), der mit dem Frontkontakt des photoaktiven Bereichs der Solarzelle in geeigneter Weise verbunden wird, eine n-Schicht verläuft, also eine Elektronen leitende Schicht mit der Folge, dass Migrationen unterbunden werden, ohne dass die Funktionstüchtigkeit der Schutzdiode beeinträchtigt wird.

Insbesondere sieht die Erfindung vor, dass die Solarzelle eine Kaskaden- oder Multi-junction-Solarzelle mit n-Teilsolarzellen mit n ≥ 2 ist. Mit anderen Worten kann die Solarzelle eine gewünschte Anzahl von p/n-Übergängen aufweisen. Insbesondere handelt es sich bei der Solarzelle um eine Triple-Zelle mit übereinander angeordneter ersten, zweiten und dritten Teilsolarzelle des Typs n/p; wobei zwischen den jeweiligen Teilsolarzellen eine Tunneldiode verläuft, dass die Solarzelle in einen photoaktiven ersten Bereich und einen die Schutzdiode frontseitig aufweisenden zweiten Bereich unterteilt ist, dessen halbleitende Schichten beabstandet zu dem von einem gemeinsamen Substrat ausgehenden photoaktiven ersten Bereich verlaufen.

Dabei sind insbesondere die Teilsolarzellen derart ausgelegt, dass diese Strahlung unterschiedlicher Wellenlänge absorbieren. So kann die erste oder Bodenzelle, eine Germaniumsolarzelle sein, über die eine Mittelzelle des Typs Ga₁₋ₓInₓAs mit z. B. 0,01 ≤ x ≤ 0,03 verläuft. Frontseitig ist bevorzugterweise eine Ga_{1-y}In_{y}P-Zelle vorgesehen, wobei vorzugsweise 0,48 ≤ y ≤ 0,51 ist.

Die entsprechenden Solarzellen sind geeignet, Strahlung der Wellenlänge 900 - 1800 nm (Bodenzelle), 660 - 900 nm (Mittelzelle) bzw. 300 - 660 nm (Front- bzw. Topzelle) zu absorbieren.

Unabhängig hiervon ist insbesondere vorgesehen, dass die Schutzdiode aus einer solarzellenseitig verlaufenden n-Schicht und einer frontseitig verlaufenden p-leitenden Schicht besteht, die jeweils aus Ga₁₋ₓInₓAs mit z. B. 0,01 ≤ x ≤ 0,03 Ga₁₋ₓ In_{y}P mit z. B. 0,48 ≤ y ≤ 0,51 bestehen.

Des Weiteren kann p⁺⁺-leitende Schicht der Tunneldiode z. B. aus Al_{1-y}Ga_{y}As mit z. B. 0,0 ≤ y ≤ 0,6 und/oder n⁺⁺-leitende Schicht der Tunneldiode aus Ga₁₋ₓInₓAs mit z. B. 0,01 ≤ x ≤ 0,03 bestehen. Ebenso sind entsprechende Schichten mit dem Materialsystem AlGaInP denkbar.

Unabhängig hiervon ist anzumerken, dass die Schichten der Schutzdiode aus einem Materialsystem bestehen sollten, das dem der Solarzelle bzw. einem der Teilsolarzellen bei einer Kaskaden- oder Multijunction-Solarzelle entspricht.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung eines der Zeichnung zu entnehmenden bevorzugten Ausführungsbeispiels.

Es zeigen:
- Fig. 1: eine Prinzipdarstellung einer Triple-Zelle mit Schützdiode und
- Fig. 2: einen Aufbau einer Triple-Zelle in ihrem photoaktiven Bereich.

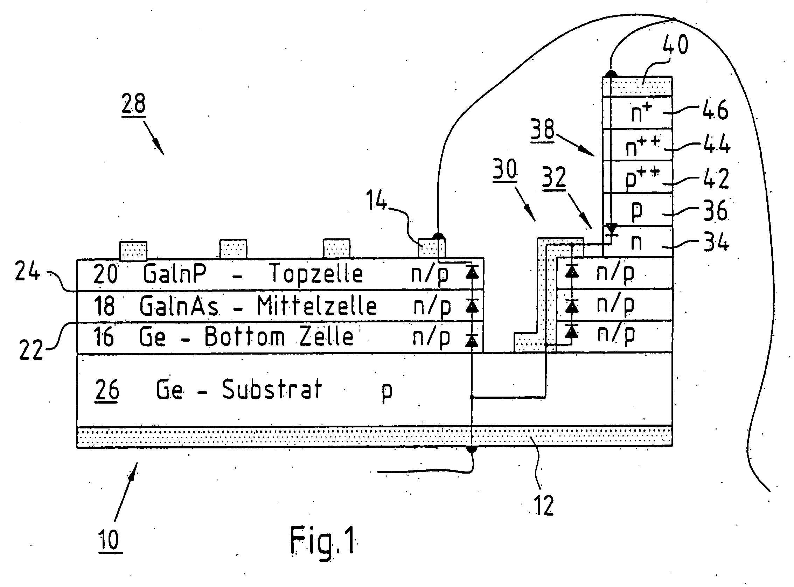

In Fig. 1 ist rein prinzipiell eine Kaskaden- oder Multijunction-Solarzelle 10 dargesiellt, die einen Rückkontakt 12 sowie einen Frontkontakt 14 umfasst. Zwischen dem Rückkontakt 12 und dem Frontkontakt 14 sind auf einem Germanium-Substrat 14, das ein p-leitendes G einkristallines Germanium sein kann, insgesamt drei Zellen 16, 18, 20 angeordnet, die voneinander durch Tunneldioden 22, 24 getrennt sind.

Die Boden- oder Bottom-Zelle 16 ist auf einem Germanium-Substrat 26 angeordnet. In das Germanium-Substrat 26, das p-leitend ist, wird der Emitter der n-leitenden Germanium-Bodenzelle 16 durch Diffusion von Arsen oder Phosphor eingebracht. Dabei ist das p-leitende Substrat bereits photoaktive Schicht der Boden- oder Bottom-Zelle 16. Sodann wird die erste Tunneldiode 22 epitaktisch aufgetragen, auf die wiederum die Mittelzelle 18 aufgebracht wird. Dabei muss eine Gitteranpassung in Bezug auf das Germanium erfolgen. Die Mittelzelle 18 besteht daher vorzugsweise aus Galliumarsenid (GaAs), das jedoch eine geringfügig unterschiedliche Gitterkonstante zu Germanium hat. Daher gibt man vorzugsweise 1 - 3 % Indium zu, damit die Gitterkonstanten aufeinander abgestimmt sind,

Auf die Mittelzelle 18 wird sodann die Tunneldiode 20 epitaktisch aufgetragen.

Die Front- oder Topzelle 20 besteht aus Gallium-Indiurn-Phosphid. Um ebenfalls eine Gitteranpassung vorzunehmen; wird Indium hinzugegeben, wobei eine Zusammensetzung von insbesondere Ga_{0.51}In_{0.49}P gewählt wird.

Entsprechende Solarzellen 10 werden üblicherweise zu einem String in Serie geschaltet.

Vorhandene Mikrokurzschlüsse in den aktiven Halbleiterschichten können bei Betrieb der Zelle 10 in Sperrrichtung zu deren Zerstörung führen. Zum Schutz gegen entsprechende Zerstörungen wird eine Schutzdiode parallel zu der Solarzelle 10 geschaltet. Hierzu kann entsprechend der Lehre der EP-A-1 056 137 ein kleiner Bereich der photoaktiven Schichten, also der Bodenzelle 16, der Mittelzelle 18 sowie der Topzelle 20 sowie zwischen diesen verlaufenden Tunneldioden 22, 24 bis zum Substrat 26 zum Beispiel durch lokales vertikales Ätzen entfernt werden. Auf den zu dem photoaktiven Bereich 28 beabstandet auf dem Substrat 12 verlaufenden Bereich 30 der Solarzelle 10 wird sodann eine Schutzdiode 32 des Typs p/n epitaktisch aufgetragen, wobei die n-Schicht 34 topzellenseitig und die p-Schicht 36 frontseitig verläuft.

Die Schichten 34, 36 untereinander bzw. zu den angrenzenden Schichten können gitterangepasst sein. Es besteht aber auch die Möglichkeit, die Zusammensetzung der Materialien der einzelnen Schicht so zu wählen, dass sich ein gitterfehlangepasstes System ergibt.

Erfindungsgemäß wird sodann auf die p-Schicht 36 der Schutzdiode 32, die bevorzugterweise dem Material der Mittelzelle 18 oder der Oberzelle 20, also Gallium-Indium-Arsenid oder Gallium-Indium-Phosphid entspricht, eine Tunneldiode 38 epitaktisch aufgetragen, wobei bevorzugtenveise die schutzdiodenseitige p⁺⁺ -Schicht 42 aus AlGaAs oder AlGaInP und die frontseitige n⁺⁺-Schicht 44 aus GaInAs oder GaAs oder InGaP besteht. Die entsprechend aufgebaute Tunneldiode 38 hat ein sehr gutes Tunnelverhalten bis zu sehr hohen Stromdichten, die in der Bypassdiode 32 vorliegen (bis zu 550 mA bei ca. 8 mm²).

Auf die n⁺⁺-Frontseitenschicht 44 der Tunneldiode 38 kann sodann unmittelbar ein Frontkontakt 40 aufgebracht werden. Bevorzugterweise ist jedoch eine zusätzliche n⁺-Kontaktschicht 46 vorgesehen, wie dies auch bei dem photoaktiven Bereich 28 der Solarzelle 10 vorgesehen ist.

Bevorzugterweise werden zur Ausbildung der Solarzelle 10 zunächst sämtliche Schichten ausgebildet bzw. epitaktisch aufgetragen, also auch die der Schutzdiode 32 und der Tunneldiode 38 sowie der zusätzlichen n⁺-Kontaktschicht 46, um anschließend durch vertikales Ätzen den photoaktiven Bereich 28 von dem Bereich 30 zu trennen, auf dem die Schutzdiode 32 mit Tunneldiode 38 und Kontaktschicht 46 verlaufen.

In der Fig. 1 ist des Weiteren ein Stromlaufplan der mit anderen Solarzellen seriell zu verschaltenden Solarzelle 10 dargestellt. In dem Ersatzschaltbild erkennt man die antiparallel zu der Solarzelle 10 geschaltete Schutzdiode 32.

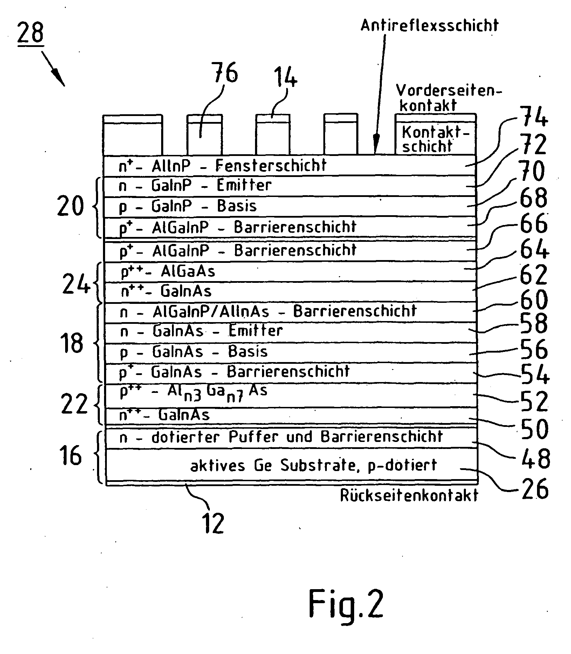

Fig. 2 ist detaillierter der Aufbau der Triple-Zelle 10 in ihrem aktiven Bereich 28 zu entnehmen, der dem Teilbereich 30 unterhalb der Schutzdiode 32 entspricht.

Auf den Rückkontakt 12 ist die Boden- oder Bottomzelle 16 aufgebracht, die sich aus dem p-dotierten aktiven Germaniumsubstrat 26 und auf dieser verlaufenden n-dotierten Bufferschicht 48 sowie Barrierenschicht zusammensetzt. Auf die Buffer- bzw. Barriereschicht 48 ist sodann eine n⁺⁺-Galium-Indium-Arsenid (GalnAs)-Schicht 50 oder GaAs-Schicht oder InGaP-Schicht und auf diese eine p⁺⁺-Al_{0,3}Ga_{0,7}As-Schicht 52 aufgetragen, die die Tunneldiode 22 bilden. Auf die Tunneldiode 22 wird sodann die Mittelzelle 18 aufgebracht, die sich aus einer p⁺-leitenden Barriereschicht 54 aus GalnAs, einer p-leitenden Basisschicht 56 in Form von GalnAs und einer n-leitenden Emitterschicht 58 in Form von GalnAs zusammensetzt. Der Anteil des Indiums ist dabei so gewählt, dass eine Gitteranpassung an die die Tunneldiode 22 bildenden Schichten und das Ge-Substrat erfolgt. Der Anteil von Indium beläuft sich vorzugsweise zwischen 1 % und 3 %.

Die Mittelzelle 18 kann sodann von einer n⁺-leitenden Barriereschicht 60 abgedeckt sein, die aus AlGaInP/AllnAs bestehen kann.

Auf der Mittelzelle 18 erstreckt sich die Tunneldiode 24 bestehend aus der n⁺⁺-leitenden unteren Schicht 62 aus GalnAs oder AlGalnP und der p⁺⁺-leitenden oberen Schicht 64 aus. AlGaAs oder AlGaInP. Bevorzugterweise besteht diese Tunneldiode aus Material mit großem Bandabstand, um eine ausreichende Lichtdurchlässigkeit für die darunter liegeriden Solarzellen zu gewährleisten. Diese Tunneldiode kann sodann von einer Barriereschicht 66 abgedeckt sein, die p⁺-leitend ist und aus AlGalnP besteht.

Auf der Tunneldiode 24 ist die Front- oder Topzelle 20 epitaktisch aufgetragen, die aus einer p⁺-leitenden Barriereschicht 68 aus GalnP, einer Basisschicht 70, die p-leitend ist und aus GalnP besteht, und einer n-leitenden Emitterschicht 72 aus GaInP zusammengesetzt ist. Die Emitterschicht 72 ist von einer Fensterschicht 74 abgedeckt, die n⁺-leitend ist und aus AllnP besteht. Da die Fensterschicht 74 sich schlecht mit dem Frontkontakt 14 kontaktieren lässt, erstreckt sich abschnittsweise auf der Fensterschicht 74 eine n-leitende Capschicht 76, die aus n-GaAs besteht:

Bezüglich des Schutzdiodenmaterials wird bevorzugterweise dasselbe Material gewählt wie das der Mittelzelle 18, nämlich GaAs mit etwas In. Grundsätzlich könnte auch das Material der Front- oder Topzelle 30, also GaInP benutzt werden. In diesem Fall wäre jedoch die Fluss-Spannung der Schutzdiode 32 größer.

Das Material der auf der Schutzdiode 32 verlaufenden Tunneldiode 38 sollte aufgrund des guten Tunnelverhaltens das der Tunneldiode 22 sein, d.h. die p⁺⁺-leitende Schicht 42 sollte aus Al_{0,3}Ga_{0,7}As und die n⁺⁺-leitende Schicht 44 aus GaInAs bestehen.

Der die n⁺-Schicht abdeckende Frontkontakt 40 ist sodann elektrisch leitend einerseits mit dem Frontkontakt 14 des photoaktiven Bereichs 28 elektrisch leitend sowie mit Rückkontakt einer in Serie geschalteten weiteren Solarzelle verbunden. Dies geschieht üblicherweise beim Verschalten von Solarzellen durch Anlöten oder Anschweißen eines Standardverbinders, wie dieser auch bei Solarzellen ohne Schutzdiode benutzt wird, wobei normalerweise eine von mehreren Schweißinseln als Schutzdiode ausgebildet ist. Die Schutzdiode kann auch bereits in die Solarzelle integriert verschaltet werden.

## Patentansprüche

1. Solarzelle mit zwischen Front- und Rückkontakt verlaufenden photoaktiven Halbleiterschichten mit integraler mit dem Frontkontakt verbindbarer Schutzdiode (Bypass-Diode) mit einer der Solarzelle entgegen gerichteten Polarität und frontseitig verlaufender p-leitender Halbleiterschicht, auf der eine Tunneldiode verläuft,
**dadurch gekennzeichnet,**
**dass** auf der Tunneldiode (38) eine n⁺-leitende Schicht (46) verläuft, über die die Schutzdiode (32) mit dem Frontkontakt (14) verbunden oder verbindbar ist.

2. Solarzelle nach Anspruch 1,
**dadurch gekennzeichnet,**
**dass** die Schutzdiode (32) aus einer solarzellenseitig verlaufenden n-leitenden Schicht (34) und einer frontseitig verlaufenden p-leitenden Schicht (36) besteht, die vorzugsweise jeweils aus GaInAs oder GaInP bestehen.

3. Solarzelle nach zumindest einem der vorhergehenden Ansprüche,
**dadurch gekennzeichnet,**
**dass** die p⁺⁺-leitende Schicht (42) der Tunneldiode (38) aus AlGaAs wie Al_{1-y}Ga_{y}As mit vorzugsweise 0,4 ≤ y ≤ 0,6 besteht.

4. Solarzelle nach zumindest einem der vorhergehenden Ansprüche,
**dadurch gekennzeichnet,**
**dass** die n⁺⁺-leitende Schicht (44) der Tunneldiode (38) aus GaInAs wie Ga₁₋ₓInₓAs mit vorzugsweise 0,01 ≤ x ≤ 0,03 oder aus GaAs oder aus InGaP besteht.

5. Solarzelle nach zumindest einem der vorhergehenden Ansprüche,
**dadurch gekennzeichnet,**
**dass** die Solarzelle (10) eine Kaskaden- oder Multijunction-Solarzelle mit n Teilsolarzellen mit n ≥ 2, insbesondere in Form einer Triple-Zelle mit übereinander angeordneter erster, zweiter und dritter Teilsolarzelle (16, 28) des Typs n/p ist.

6. Solarzelle nach Anspruch 5,
**dadurch gekennzeichnet,**
**dass** photoaktive Schichten der ersten Teilzelle oder Bodenzelle (16) aus Germanium bestehen.

7. Solarzelle nach Anspruch 5 oder 6,
**dadurch gekennzeichnet,**
**dass** photoaktive Schichten der zweiten Teilzelle oder Mittelzelle (18) aus GalnAs wie Ga₁₋ₓInₓAs mit vorzugsweise 0,01 ≥ x ≥ 0,03 bestehen.

8. Solarzelle nach zumindest einem der Ansprüche 5, 6 oder 7,
**dadurch gekennzeichnet,**
**dass** photoaktive Schichten der dritten Teilzelle oder Topzelle (20) aus GalnP wie Ga_{1-z}In_{z}P mit vorzugsweise 0,48 ≥ z ≥ 0,52 bestehen.

9. Solarzelle nach zumindest einem der vorhergehenden Ansprüche,
**dadurch gekennzeichnet,**
**dass** die Solarzelle (10) aus einem photoaktiven ersten Bereich (28) und einem die Schutzdiode (36) frontseitig aufweisenden zweiten Bereich (30) besteht, wobei der erste Bereich (28) und der zweite Bereich zueinander beabstandet von einem gemeinsamen Substrat (26) ausgehen.

10. Solarzelle nach zumindest einem der Ansprüche 5, 6, 7, oder 8,
**dadurch gekennzeichnet,**
**dass** die Schichten (34, 369) der Schutzdiode (32) aus Materialien bestehen, die den Schichten einer der Teilsolarzellen (16, 18, 20) der Kaskaden- oder Multijunction-Solarzellen (28) entsprechen.

11. Solarzelle nach zumindest einem der vorhergehenden Ansprüche,
**dadurch gekennzeichnet,**
**dass** die die Schutzdiode (32) mit dem Frontkontakt (14) der Solarzelle (10) verbindende n⁺-leitende Schicht (46) von einem metallischen Kontakt (40) abgedeckt ist, der mit dem Frontkontakt (14) der photoaktiven Schichten der Solarzelle (28) verbunden ist.

## Claims

1. Solar cell with photoactive semiconductor layers extending between front and rear contacts with an integrated protective diode (bypass diode), which is connectable to the front contact, with a polarity opposite to that of the solar cell, and, extending at its front side, a p-conducting semiconductor layer, on which extends a tunnel diode,
**characterized in**
**that** on the tunnel diode (38) extends an n⁺-conducting layer (46), via which the protective diode (32) is connected or connectable to the front contact (14).

2. Solar cell according to claim 1
**characterized in**
**that** the protective diode (32) consists of an n-conducting layer (34) extending on the solar-cell side and a p-conducting layer (36) extending on the front side, which preferably each consist of GaInAs or GaInP.

3. Solar cell according to at least one of the preceding claims,
**characterized in**
**that** the p⁺⁺-conducting layer (42) of the tunnel diode (38) consists of AlGaAs such as Al_{1-y}Ga_{y}As, where preferably 0.0 ≤ y ≤ 0.6.

4. Solar cell according to at least one of the preceding claims,
**characterized in**
**that** the n⁺⁺-conducting layer (44) of the tunnel diode (38) consists of GaInAs, such as Ga₁₋ₓInₓAs, where preferably 0.01 ≤ x ≤ 0.03, or of GaAs or of InGaP.

5. Solar cell according to at least one of the preceding claims,
**characterized in**
**that** the solar cell (10) is a cascade or multi-junction solar cell with n sub solar cells where n ≥ 2, in particular in the form of a triple cell with first, second, and third sub solar cell (16, 28) of n/p type arranged one above the other.

6. Solar cell according claim 5,
**characterized in**
**that** photoactive layers of the first sub cell or bottom cell (16) consist of germanium.

7. Solar cell according to claim 5 or 6,
**characterized in**
**that** photoactive layers of the second sub cell or centre cell (18) consist of GaInAs such as Ga₁₋ₓInₓAs, where preferably 0.01 ≥ x ≥ 0.03.

8. Solar cell according to at least one of the claims 5, 6 or 7,
**characterized in**
**that** photoactive layers of the third sub cell or top cell (20) consist of GaInP such as Ga_{1-z}In_{z}P, where preferably 0.48 ≥ z ≥ 0.52.

9. Solar cell according to at least one of the preceding claims,
**characterized in**
**that** the solar cell (10) consists of a photoactive first region (28) and a second region (30) having the protective diode (36) on its front side, the first region (28) and the second region extending from a common substrate (26) at a spacing from one another.

10. Solar cell according to at least one of the claims 5, 6, 7 or 8,
**characterized in**
**that** the layers (34, 36) of the protective diode (32) consist of materials that correspond to those of the layers of one of the sub solar cells (16, 18, 20) of the cascade or multi-junction solar cells (28).

11. Solar cell according to at least one of the preceding claims,
**characterized in**
**that** the n⁺-conducting layer (46) connecting the protective diode (32) to the front contact (14) of the solar cell (10) is covered by a metallic contact (40) which is connected to the front contact (14) of the photoactive layers of the solar cell (28).

## Revendications

1. Cellule solaire comprenant des couches semi-conductrices photoactives disposées entre les contacts avant et arrière, pourvue d'une diode de protection intégrale pouvant être reliée au contact avant (diode de dérivation), de polarité opposée à celle de la cellule solaire et d'une couche semi-conductrice de conductivité p, située du côté avant, sur laquelle se trouve une diode tunnel,
**caractérisée en ce**
**qu'**une couche de conductivité n⁺ (46), au moyen de laquelle la diode de protection (32) est ou peut être reliée au contact avant (14), est disposée sur la diode tunnel (38).

2. Cellule solaire selon la revendication 1,
**caractérisée en ce que**
la diode de protection (32) est constituée d'une couche de conductivité n, disposée côté cellule solaire, et d'une couche de conductivité p (36) disposée côté avant, qui sont composées respectivement de préférence de GaInAs ou de GaInP.

3. Cellule solaire selon au moins l'une des revendications précédentes,
**caractérisée en ce que**
la couche de conductivité p⁺⁺ (42) de la diode tunnel (38) est composée de AlGaAs, par exemple Al_{1-y}Ga_{y}As avec de préférence 0,0 ≤ y ≤ 0,6.

4. Cellule solaire selon au moins l'une des revendications précédentes,
**caractérisée en ce que**
la couche de conductivité n⁺⁺ de la diode tunnel (38) est composée de GalnAs, par exemple Ga₁₋ₓInₓAs avec de préférence 0,01 ≤ x < 0,03 ou de GaAs ou de InGaP.

5. Cellule solaire selon au moins l'une des revendications précédentes,
**caractérisée en ce que**
la cellule solaire (10) est en cascade ou à jonctions multiples de n cellules solaires partielles, avec n ≥ 2, en particulier sous forme d'une triple cellule comportant trois cellules solaires partielles (16, 28) superposées du type n/p.

6. Cellule solaire selon la revendication 5,
**caractérisée en ce que**
les couches photoactives de la première cellule partielle ou cellule inférieure (16) sont en germanium.

7. Cellule solaire selon la revendication 5 ou 6,
**caractérisée en ce que**
les couches photoactives de la deuxième cellule partielle ou cellule médiane (18) sont en GalnAs, par exemple Ga₁₋ₓInₓAs avec de préférence 0,01 ≥ x ≥ 0,03.

8. Cellule solaire selon la revendication 5, 6 ou 7,
**caractérisée en ce que**
les couches photoactives de la troisième cellule partielle ou cellule supérieure (20) sont en GalnP, par exemple Ga_{1-z}In_{z}P avec de préférence 0,48 ≥ z ≥ 0,52.

9. Cellule solaire selon au moins l'une des revendications précédentes,
**caractérisée en ce que**
la cellule solaire (10) est composée d'une première zone photoactive (28) et d'une deuxième zone (30) comportant côté avant la diode de protection (36), la première zone (28) et la deuxième zone (30), espacées l'une de l'autre, partant d'un support commun (26).

10. Cellule solaire selon au moins l'une des revendications 5, 6, 7 ou 8,
**caractérisée en ce que**
les couches (34, 36) de la diode de protection (32) sont en matériaux correspondant aux couches de l'une des cellules solaires partielles (16, 18, 20) des cellules solaires en cascade ou à jonctions multiples (28).

11. Cellule solaire selon au moins l'une des revendications précédentes,
**caractérisée en ce que**
la couche de conductivité n⁺ (46) reliant la diode de protection (32) avec le contact avant (14) de la cellule solaire (10) est recouverte d'un contact métallique (40) relié au contact avant (14) des couches photoactives de la cellule solaire (28).
